# EUROPÄISCHE PATENTSCHRIFT

(11) **EP 0 706 207 B1**
(45) Veröffentlichungstag und Bekanntmachung des Hinweises auf die Patenterteilung: **30.01.2002**
(21) Anmeldenummer: 95113831.2
(22) Anmeldetag: 04.09.1995
(51) Int. Cl.: H01L 21/312

(54) **Verfahren zur Reduzierung der Oberflächenrekombinationsgeschwindigkeit von Silizium**
Process to reduce the surface recombination rate of silicon
Procédé pour reduire la vitesse de recombinaison en surface du silicium

(30) Priorität: 12.09.1994 DE 4432294
(43) Veröffentlichungstag der Anmeldung: 10.04.1996
(73) Patentinhaber: ATMEL Germany GmbH, 74072 Heilbronn (DE)
(72) Erfinder: Arndt, Wolfgang, D-74078 Heilbronn (DE); Graff, Klaus, Dr., D-74076 Heilbronn (DE); Hamberger, Alfons, D-74831 Gundelsheim (DE); Heim, Petra, D-74072 Heilbronn (DE)
(74) Vertreter: Maute, Hans-Jürgen, Dipl.-Ing.

(56) Entgegenhaltungen:
- WO-A-94/14188
- US-A- 3 684 592
- US-A- 4 608 097

## Beschreibung

Die Erfindung betrifft ein Verfahren zur Reduzierung der Oberflächenrekombinationsgeschwindigkeit von Siliziumscheiben.

Bei der Herstellung von elektronischen Bauelementen aus Silizium ist für deren Funktion in der Regel eine Maßnahme zur Reduzierung der Oberflächenrekombination ebenso notwendig, wie auch für die Anwendung verschiedener meßtechnischer und analytischer Methoden. Dies trifft besonders auf die Bestimmung der Volumen-Rekombinations-Lebensdauer zu, die ein Maß für die Reinheit von Silizium hinsichtlich elektrisch aktiver Verunreinigungen ist. Für ihre Bestimmung gilt jedoch in der Regel die Voraussetzung, daß die kleinste Abmessung der Probe mindestens das Vierfache der Diffusionslänge der freien Ladungsträger beträgt. Diese Voraussetzung ist in der Regel für Standard-Silizium-Scheiben nicht gegeben, da deren Dicke meist kleiner ist als die Diffusionslänge der Ladungsträger. Nur wenn die Oberflächenrekombinationsgeschwindigkeit hinreichend klein wird, d.h. in einen Bereich kleiner als 100 cm/s kommt, ist es möglich, auch an Si-Scheiben mit Standarddicke die Volumenlebensdauer mit hinreichender Genauigkeit zu messen, um so die Reinheit von Si-Ausgangsscheiben vor und nach technologischen Prozessen zur Herstellung von Bauelementen zu überwachen.

Eine Reduzierung der Oberflächenrekombinationsgeschwindigkeit von Silizium kann durch das Aufwachsen einer thermischen Siliziumdioxidschicht in oxidierender Atmosphäre bei Temperaturen im Bereich von ca 800 - 1200 °C erreicht werden. In der Literatur und im Sprachgebrauch sind solche Schichten häufig auch unter dem umfassenderen Begriff Oberflächenpassivierung zu finden. Hier wird jedoch in der Regel der zusätzliche Aspekt " Schutz vor Umwelteinflüssen" einbezogen. Bedingt durch die ausgezeichneten mechanischen, chemischen und elektronischen Eigenschaften der SiO₂ Schicht wird sie heute im Bereich der Silizium- Halbleitertechnologie fast überall eingesetzt.

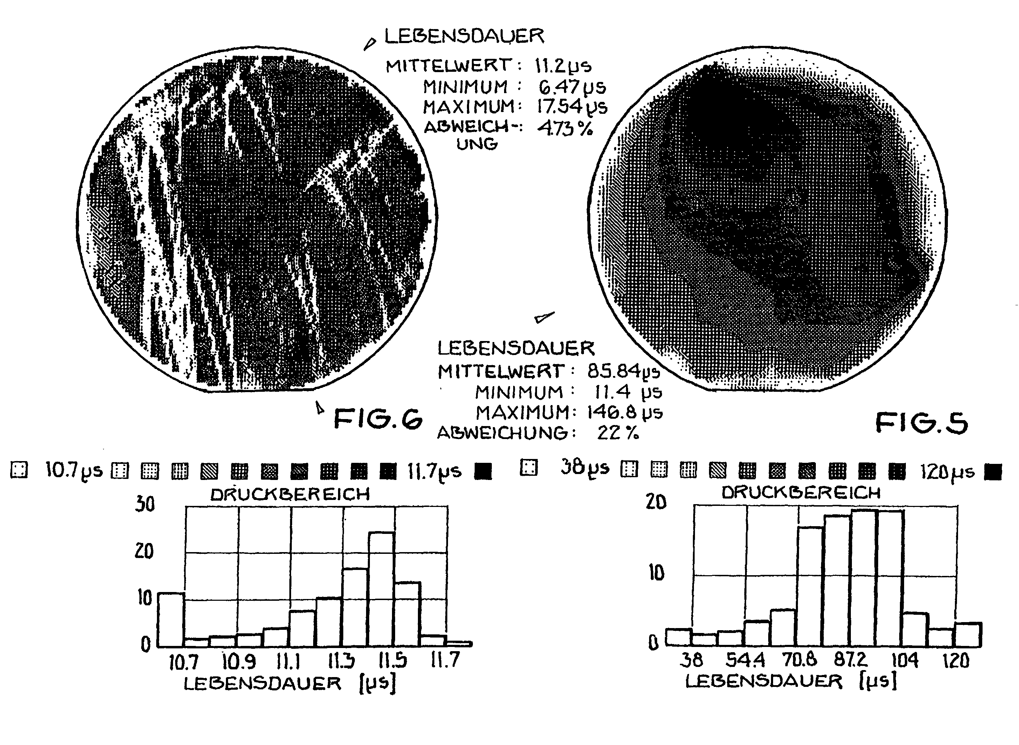

Es gibt jedoch einige Anwendungen, wo diese Schicht nicht zufriedenstellend eingesetzt werden kann. Dies ist der Fall einerseits bei Bauelementen, die eine hohe Temperatur/Zeit-Belastung bei der Herstellung dieser Schicht nicht vertragen. Anders liegt der Fall bei der Messung der Volumenlebensdauer. So ist beim Nachweis von Schwermetallen in Si-Scheiben im ppb-Bereich durch Messung der Trägerlebensdauer der Einfluß einer Oxidation auf den Schwermetallgehalt der Scheibe durch Kontamination, Segregation, Prezipitation und Abdampfen nur sehr schwer, wenn überhaupt, zu quantifizieren. Abhängig vom Verhältnis der Kontaminationslevel von Scheibe und Oxidationsrohr kann einerseits eine Eindiffusion von Verunreinigungen aus dem Rohr in die zu untersuchende Scheibe auftreten. Andererseits ist es genauso gut möglich, daß Verunreinigungen aus der Scheibe ausdiffundieren, sich im Oxid anreichern bzw. homogen oder heterogen ausscheiden. In all den genannten Fällen repräsentiert die anschließend gemessene Trägerlebensdauer nicht mehr die ursprüngliche Reinheit der Scheibe. Ein weiteres Problem der thermischen Oxidation besteht in der schlechten Reproduzierbarkeit der Zustandsdichte der Grenzfläche Si - SiO₂, die die Oberflächenrekombination bestimmt. Fig. 5 zeigt die Lebensdauerverteilung einer thermisch oxidierten Scheibe, mit einer geringen durchschnittlichen Lebensdauer von 85,84 µs, die weitgehend durch die Oberflächenrekombination an einer nicht optimalen Si - SiO₂-Grenzfläche bestimmt ist.

Um das Problem der thermischen Belastung zu umgehen, besteht die Möglichkeit, statt der thermisch gewachsenen Oxidschicht eine mit dem CVD (Chemical Vapor Deposition) Verfahren oder einer seiner Varianten PECVD (Plasma Enhanced CVD) oder Photo-CVD abgeschiedene SiO₂-Schicht zu verwenden. Hier kommen je nach Verfahren Temperaturen von ca. 100 °C bis 900°C zur Anwendung. Ein weiterer Vorteil dieser Verfahren ist, daß auch Schichten wie Siliziumnitrid Si₃N₄ oder Siliziumoxinitrid SiOₓN_{y} abgeschieden werden können.

Ein gravierender Nachteil dieser bisher bekannten abgeschiedenen Schichten ist ihre geringe Erniedrigung der Oberflächenrekombinationsgeschwindigkeit. Sie sind daher im weiteren Sinne den Passivierungsschichten zuzurechnen, bei denen der Aspekt "Schutz vor Umwelteinflüssen" im Vordergrund steht. Für Bauelementanwendungen werden sie nur in Verbindung mit einer direkt auf dem Silizium gewachsenen dünnen thermischen SiO₂-Schicht eingesetzt. Für den analytischen Bereich ist aus demselben Grund, und weil auch hier anlagenspezifische Kontaminationsprobleme bestehen, bisher keine entsprechende Anwendung bekannt.

Für den analytischen Anwendungsfall kommt hier erschwerdend zum Tragen, dass die Diffusionskoeffizienten der interessierenden Metalle in Si fast immer um Größenordnungen höher sind als diejenigen der Dotierelemente P, B, As und Sb. Dies führt dazu, daß Temperatur / Zeit-Belastungen, die selbst für hochempfindliche Bauelemente erträglich sind, hier unübersehbare Nebenwirkungen verursachen, wie sie bereits bei der thermischen Oxidation erwähnt sind.

Weiter ist bekannt, dass Wasserstoff und Halogene (F, Cl, Br, J und At) direkt auf der Si-Oberfläche die Oberflächenrekombinationsgeschwindigkeit reduzieren. Dies ist beispielsweise gemäß der US 4, 608, 097 durch eine Behandlung der Si-Oberfläche mit Fluorwasserstoffsäure (HF) zu erreichen. Gravierender Nachteil der Methode ist, dass die Wirkung (Unterdrückung der Oberflächenrekombination) nach Entnahme der Scheibe aus der Flüssigkeit unter dem Einfluß von Luftsauerstoff bereits nach wenigen Minuten nahezu verschwunden ist. Damit ist eine Anwendung im Bauelementebereich nicht möglich. Eine bekannte Anwendung im analytischen Bereich ist das "Elymatverfahren" zur Messung der Ladungsträgerdiffusionslänge in Si-Scheiben.
Hier liegt die Scheibe während der Messung in einer Küvette mit verdünnter HF. Wegen der mit dem Umgang von HF verbundenen Gefahren muß ein relativ großer apparativer Aufwand getrieben werden, um das Bedienungspersonal nicht unnötig zu gefährden.

Darauf beruht beispielsweise das in der WO-A-9414188 beschriebene µ-PCD-In-Situ-volumen-Lebensdauermeßverfahren für einen über Mikrowellen erfasstes Abklingen der Fotoleitfähigkeit in einem Silizium-Wafer, bei dem folgende Verfahrensschritte durchgeführt werden:
(a) Bereitstellen einer Passivierungslösung, die eine Jod, konzentrierte Lauge oder Fluorionen aufweisende Säure aufweist, um die Oberflächenrekombinationsgeschwindigkeit des Wafers zu verringern;
(b) Umgeben des Wafers mit der Passivierungslösung derart, dass die obere Außenfläche und die untere Außenfläche des Wafers wenigstens mit einer dünnen Schicht der Lösung bedeckt sind, wodurch die Oberflächenrekombinationsgeschwindigkeit des Wafers verringert wird;
(c) Durchführen der µ-PCD-ln-Situ-Volumen-Lebensdauermessungen, während der Wafer mit der Passivierungsschicht bedeckt ist.

In der US 3, 684, 592 ist ein Passivierungsverfahren eines Halbleiterbauelementes beschrieben, wonach eine in einem ersten Prozess erzeugte temporäre Schicht in einem zweiten Prozess konvertiert wird. Zur Durchführung des ersten Prozesses wird das Halbleiterbauelement zunächst mittels Erzeugung der temporären Passivierung in eine gesättigte Lösung aus reinem Jod und einem Lösungsmittel, wie beispielsweise Methanol getaucht. Das überschüssige Jod wird mit reinem Jod abgespült um damit auch Reste der Ätzlösung zu entfernen. Anschließend wird das Halbleiterelement mit Azeton gespült um überschüssiges Jod zu entfernen und dabei chemische fest an die saubere Oberfläche des Halbleiterkörpers gebundenes Jod in Form der Passivierungsschicht zu erzeugen. Mit einer solchen Schicht wird eine ideale Oberfläche zur Passivierung geschaffen. Die eigentliche Passivierungsschicht wird in dem zweiten Prozess durch Behandlung des Halbleiterkörpers mit einer heißen Silanlösung und anschließender Wärmebehandlung in Vakuum erzeugt.

Ein in neuer Zeit bekannt gewordenes Verfahren ist das Einbringen von frisch mit HF gebeizten Si-oberflächen in alkoholische Jod- oder Bromlösung; wie es beispielsweise von H. Msaad, J. Michel, J.J. Lappe und L.C. Kimmerling in "Electronic Passivation of Silicon Surface by Halogens" ("Journal of the Electrochemical Society", 1994) beschrieben wird. Dort werden Oberflächenrekombinationsgeschwindigkeiten von kleiner 1 cm/s erreicht, was im Vergleich zu ca. 100 cm/s, die mit thermischem SiO₂ erreicht werden, ein hervorragender Wert ist. Ein Nachteil dieses Verfahrens ist, ebenso wie beim Vorangehenden, daß die Wirkung nur in der Lösung längere Zeit erhalten bleibt, wobei sich hier das wesentlich geringere Gefahrenpotential bei Umgang mit alkoholischer jodlösung im Vergleich zur HF vorteilhaft auswirkt. Trotzdem bedeutet die Handhabung der Flüssigkeit einen erheblichen zusätzlichen Aufwand.

Die Aufgabe der Erfindung gemäß dem Anspruch 1 besteht darin, ein einfach ausführbares Verfahren anzugeben, mit dem die Oberflächenrekombinationsgeschwindigkeit von Silizium auf Werte kleiner oder gleich 100 cm/s reduziert werden kann und das außerdem eine einfache Handhabung der damit behandelten Si-Bauelemente oder Si-Scheiben erlaubt.

Die Lösung dieser Aufgabe ist durch die Merkmale des Anspruches 1 gegeben.

Es zeichnet sich durch die folgenden Schritte aus:

Zunächst wird die Si-Oberfläche gereinigt, da in der Regel jede Si-Oberfläche eine ca. 2 bis 4 mm dicke Siliziumdioxidschicht (SiO₂) aufweist. Vorzugsweise kann diese SiO₂-Schicht mit Fluorwasserstoffsäure (HF) abgeätzt werden. Nach dem Trocknen der Si-Oberfläche wird ein Lack auf die Oberfläche der Si-Scheibe bei einer Temperatur von weniger als 100°C aufgebracht, vorzugsweise jedoch bei Raumtemperatur, so dass durch Trocknen dieses Lackes eine elektrisch nichtleitende Schicht entsteht. Das Aufbringen des Lackes kann beispielsweise durch Aufsprühen, Aufspinnen, Aufpinseln oder auch durch Tauchen erfolgen.

Je nach Art des verwendeten Lackes führt der Trocknungsvorgang zur Verfestigung des Lackes, da beispielsweise ein in dem Lack möglicherweise vorhandenes Lösungsmittel verdampft oder eine chemische Reaktion mit Reaktionspartner aus der Schicht oder aus der Umgebung (beispielsweise Luftsauerstoff, feuchte Luft) zu einer Gelbildung bzw. zu einer Änderung des Aggregatzustandes führt oder eine Abkühlung des bei einer über der Raumtemperatur liegenden Temperatur aufgebrachten Lackes dieser in eine feste Schicht umwandelt. Zur analytischen Verwendung des erfindungsgemäßen Verfahrens, also um die Trägerlebensdauer von Si-Standardscheiben zu messen, muß die aufgebrachte Schicht transparent für den für die Messung verwendeten Lasers sein, also beispielsweise im Bereich von 900 nm.

Durch diese Maßnahmen wird die Oberflächenrekombinationsgeschwindigkeit kleiner 100 cm/s, ohne daß eine merkliche Temperaturbelastung in der Si-Scheibe bzw. der Si-Halbleiterbauelemente auftritt. Dieser Wert ist hinreichend klein sowohl für die Funktion von Halbleiterbauelementen als auch für die Anwendung analytischer Methoden wie z.B. die Messung der Ladungsträgerlebensdauer in Si-Scheiben zur Überwachung der Kontamination mit Schwermetallen wie Eisen oder Gold.

Als Lack kann vorzugsweise ein Stoff mit organischer Grundsubstanz eingesetzt werden, wie beispielsweise ein natürliches oder künstliches Harz, das desweiteren als Zusatzstoff ein Halogen, vorzugsweise Jod enthält. Vorzugsweise wurden besonders gute Ergebnisse mit Jod enthaltendem Kolophonium, das aus Balsam-, Wurzel- oder Tallharz gewonnen wird, erzielt. Gleichfalls gute Ergebnisse liefert auch ein auf der Stoffgruppe von Alkydharzen basierender Lack, wie beispielsweise Aftalat, gute Ergebnisse. Ferner hat sich gezeigt, daß auch ein physikalisch trocknender Klar- oder Transparentlack zu den gewünschten Ergebnissen führt, so zum Beispiel der auf Cellulosenitrat-Basis hergestellte Zaponlack.

Schließlich führt auch die Verwendung von Polysiloxanen, wie beispielsweise Siliconlack zu brauchbaren Ergebnissen.

Im folgenden soll das erfindungsgemäße Verfahren anhand von Ausführungsbeispielen dargestellt und erläutert werden. Es zeigen:
- Figur 1: die örtlich Verteilung der Minoritätsträger-Lebensdauer einer mit dem erfindungsgemäßen Verfahren behandelten Siliziumscheibe,
- Figur 2: die örtliche Verteilung der Minoritäts-Lebensdauer einer mit dem erfindungsgemäßen Verfahren behandelten weiteren Siliziumscheibe,
- Figur 3: die örtliche Verteilung der Minoritäts-Lebensdauer einer mit dem erfindungsgemäßen Verfahren behandelten weiteren Siliziumscheibe, und
- Figur 4: eine schematische Schnittdarstellung eines mit dem erfindungsgemäßen Verfahren behandelten Silizium-Bauelementes.

Ein erstes Ausführungsbeispiel betrifft die Ladungsträgerlebensdauermessung an Si-Scheiben nach dem µPCD Verfahren ( Microwave Photoconductive Decay) zur Überwachung der Kontamination mit elektrisch aktiven Metallen wie Eisen oder Gold. Um Oxidschichten auf der Oberfläche zu entfernen wird die zu untersuchende Scheibe in Fluorwasserstoffsäure eingelegt. Nachdem sämtliche Oxidreste entfernt sind, was an einer hydrophoben Oberfläche erkennbar ist, wird die Scheibe in deionisiertem Wasser gründlich gespült und anschließend mit Stickstoff trockengeblasen. Anschließend wird die Scheibe beispielsweise beidseitig mit einem handelsüblichen Lötlack, basierend auf Kolophonium mit halogenhaltigen Zusätzen, beispielsweise Fluor, aus einer Sprühdose mit FCKW-Treibgas bei Raumtemperatur besprüht. Nachdem die Schicht berührungstrocken ist, wird die Scheibe in ein Magazin gestellt und dieses in eine Meßapparatur.

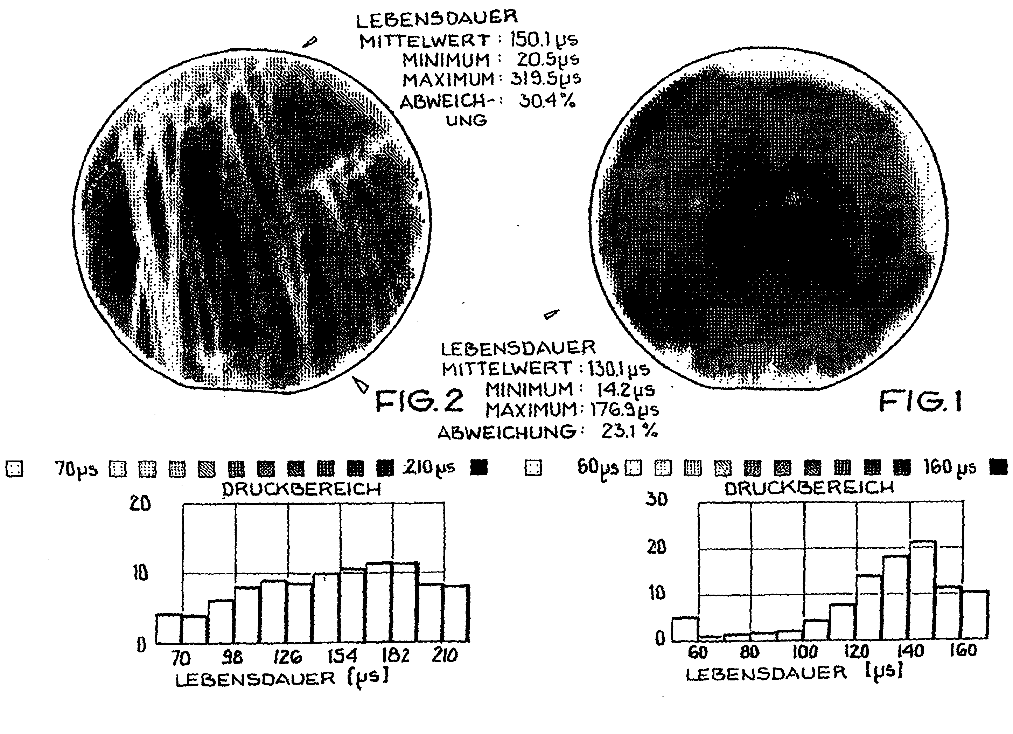

Figur 1 zeigt die örtliche Verteilung der Lebensdauerwerte einer solchen Siliziumscheibe, wobei zu Vergleichszwecken die gleiche Si-Scheibe thermisch oxydiert wurde und deren Verteilung der Lebensdauerwerte die Figur 5 zeigt. Der Vergleich zeigt für die mit dem erfindungsgemäßen Verfahren behandelten Si-Scheibe wesentlich höhere Werte als für die Si-Scheibe mit oxydierter Oberfläche. Es ergibt sich aus Figur 1 ein Mittelwert von 130,1 µs gegenüber einem Mittelwert von lediglich 85,84 µs nach Figur 5.

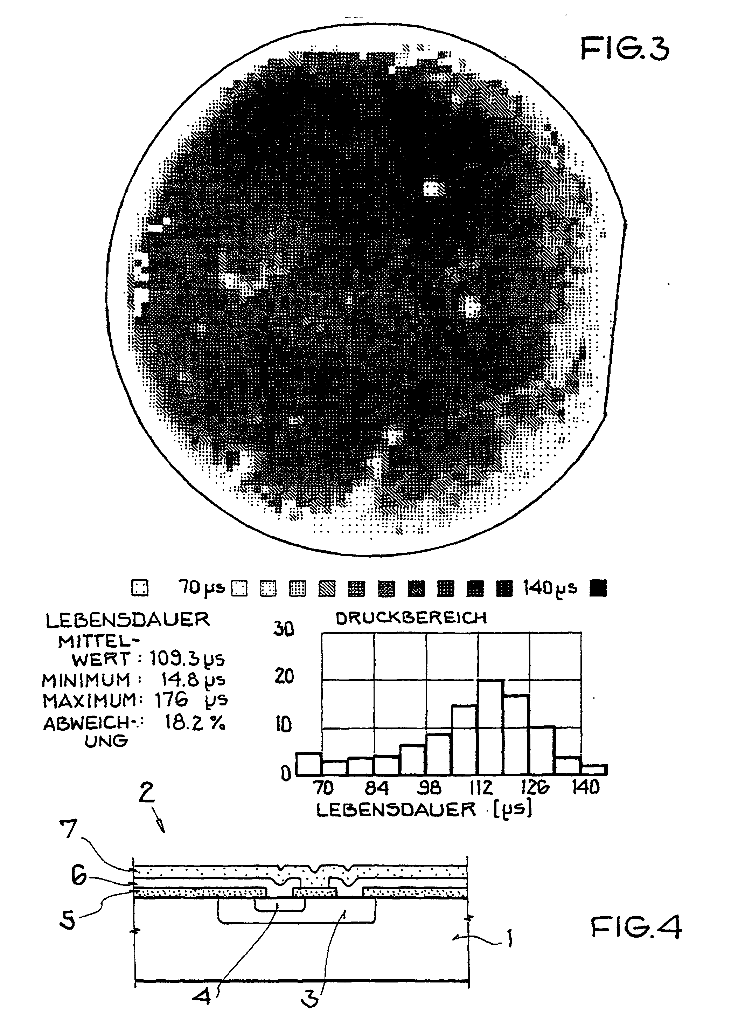

Ein weiteres Ausführungsbeispiel wurde mit einer Si-Scheibe durchgeführt, die durch ein defektes Betriebsmittel spurenweise mit Eisen kontaminiert war. Figur 6 zeigt die Lebensdauerwerte dieser Si-Scheibe, die lediglich als Oberflächenpassivierung das sogenannte natürliche Raumoxid aufweist, weshalb auch der Mittelwert sehr niedrig, nämlich nur 11,2 µs ist. Wird die gleiche Scheibe entsprechend dem ersten Ausführungsbeispiel behandelt, erhält man die Lebensdauerverteilung nach Figur 2, die wesentlich höhere Lebensdauerwerte zeigt, nämlich einen Mittelwert von 150,1 µs. Beide Figuren 2 und 6 zeigen die gleichen, die Kontamination anzeigende Konturen, wobei jedoch wegen der größeren Diffusionslänge der Minoritätsträger aufgrund der größeren effektiven Lebensdauer die Konturen in Figur 2 deutlich weniger scharf begrenzt sind.

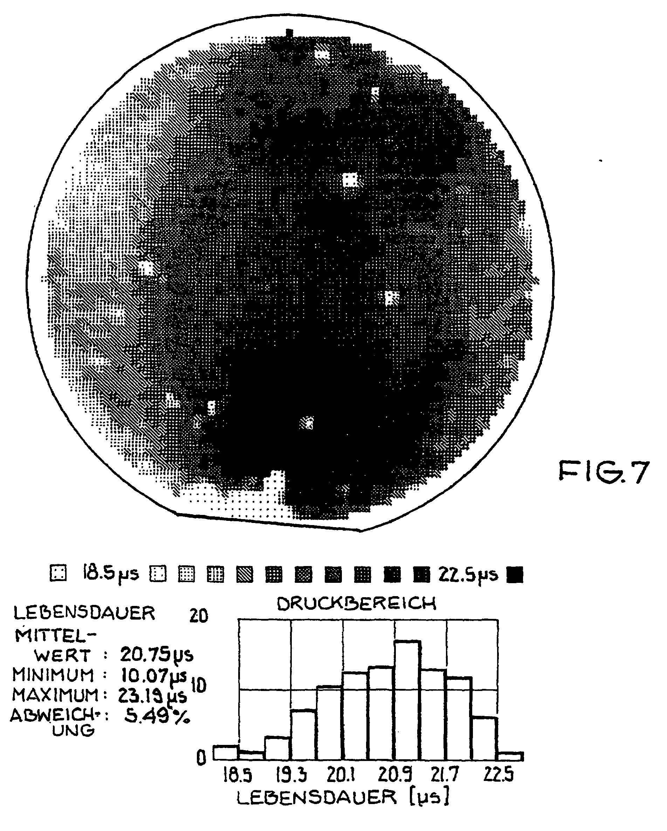

Bei einem dritten Ausführungsbeispiel zur Oberflächenbehandlung einer Si-Scheibe wird eine Lösung aus 73,75 g Isopropanol, 25 g Kolophonium und 1,25 g Jod vorbereitet. Die zu untersuchende Scheibe wird zunächst 10 s in einer Mischung aus HF:HNO gebeizt. Hierbei wird ca. 1 µm Silizium abgetragen. Wie oben beschrieben, wird dann in HF gebeizt, gründlich gespült und getrocknet. Anschließend wird die Scheibe beidseitig mit der vorbereiteten Lösung durch Auftragen mit dem Pinsel bei Raumtemperatur beschichtet. Nachdem die Schicht berührungstrocken ist, wird die Scheibe in die Meßapparatur gegeben. Die so erzielten Lebensdauerwerte sind in Figur 3 dargestellt und sind höher als die Werte einer mit SiO₂- Passivierung versehenen Si-Scheibe, die die Figur 7 zeigt. So beträgt nach Figur 7 der Mittelwert lediglich 20,75 µs, der nach Figur 3 auf 109,3 µs angestiegen ist. Dies ist ein Hinweis auf eine stärkere Reduzierung der Oberflächenrekombination, was wiederum bedeutet, daß der eigentlich interessierende Wert der Volumenlebensdauer genauer bestimmt ist.

Anstatt der in dem ersten und dritten Ausführungsbeispiel angegebenen Lacke kann auch Alftalat, Zaponlack oder Siliconlack verwendet werden.

Das erfindungsgemäße Verfahren kann mit Vorteil bei der Herstellung von Si-Bauelementen zur Reduzierung der Oberflächenrekombinationsgeschwindigkeit verwendet werden.

Hierzu zeigt Figur 4 einen Ausschnitt aus einer Si-Scheibe 1, in die Bauelemente, beispielsweise ein Transistor 2 mit Basiszone 3 und Emitterzone 4 integriert ist. Nach Herstellung dieser Zonen wird auf der Si-Oberfläche eine Schicht 5 aufgebracht, die beispielsweise nach dem ersten oder zweiten Ausführungsbeispiel erzeugt wird und zu einer unter 100 cm/s liegenden Oberflächenrekombinationsgeschwindigkeit führt. Anschließend wird diese Schicht 5 mit bekannten Methoden strukturiert, um darauf eine Leitungsstruktur 6, beispielsweise aus Aluminium zu erzeugen. Abschließend wird eine Passivierungsschicht 7, beispielsweise aus Polyimid abgeschieden. Anstatt einer solchen Polyimidschicht kann auch eine gemäß dem ersten oder zweiten Ausführungsbeispiel erzeugte Schicht verwendet werden.

Der Vorteil der Verwendung der erfindungsgemäßen Schicht zur Reduzierung der Oberflächenrekombinationsgeschwindigkeit im Zusammenhang mit der Herstellung von Si-Halbleiterbauelementen besteht darin, daß diese Schicht bei Temperaturen von weniger als 100°C, insbesondere bei Raumtemperatur erzeugbar ist, so daß die Temperaturbelastung des Bauelementes gering bleibt.

## Patentansprüche

1. Verfahren zur Reduzierung der Oberflächenrekombinationsgeschwindigkeit von Siliziumscheiben, bei dem in der aufgeführten Reihenfolge die Verfahrensschritte
a) Reinigen der Siliziumoberfläche, und anschließendes
b) Trocknen der Silliziumoberfläche
in normaler Raumatmosphärenumgebung durchgeführt werden und sich daran folgende Verfahrensschritte anschließen:
c) Auftragen eines Lackes bei einer Temperatur von weniger als 100°C, und
d) Trocknen dieses aufgetragenen Lackes in normaler Raumatmosphäre zur Erzeugung einer elektrisch nichtleitenden Schicht.

2. Verfahren nach Anspruch 1, **dadurch gekennzeichnet, daß** ein Lack verwendet wird, der zu einer transparenten Schicht führt.

3. Verfahren nach Anspruch 1 oder 2, **dadurch gekennzeichnet, daß** der Lack bei Raumtemperatur von ca. 25 °C aufgebracht wird.

4. Verfahren nach einem der Ansprüche 1 - 3, **dadurch gekennzeichnet, daß** der Lack eine organische Grundsubstanz aufweist.

5. Verfahren nach Anspruch 4, **dadurch gekennzeichnet, daß** als Grundsubstanz ein natürliches Harz oder ein Alkydharz verwendet wird.

6. Verfahren nach Anspruch 5, **dadurch gekennzeichnet, daß** Kolophonium verwendet wird.

7. Verfahren nach Anspruch 5, **dadurch gekennzeichnet, daß** Alftalat verwendet wird.

8. Verfahren nach einem der vorangehenden Ansprüche, **dadurch gekennzeichnet, daß** die elektrisch nichtleitende Schicht Halogene in Konzentration von mehr als 0,1 Volumen/% enthält.

9. Verfahren nach Anspruch 8, **dadurch gekennzeichnet, daß** als Halogen Jod eingesetzt wird.

10. Verfahren nach Anspruch 4 **dadurch gekennzeichnet, daß** die Grundsubstanz des Lackes im wesentlichen aus Polysiloxanen besteht.

11. Verfahren nach einem der vorangehenden Ansprüche, **dadurch gekennzeichnet, daß** eine weitere Schicht als Passivierungsschicht aufgebracht wird.

12. Verfahren nach einem der Ansprüche 1 - 10, **dadurch gekennzeichnet, daß** eine transparente, nicht leitende Folie auf die Schicht aufgebracht wird.

13. Verwendung des Verfahrens nach einem der vorangehenden Ansprüche zur Herstellung von Silizium-Halbleiterbauelementen.

14. Verwendung des Verfahrens nach einem der Ansprüche 2 - 12 zur Vorbereitung einer Messung der Minoritätsträgerlebensdauer in Standard-Siliziumscheiben.

## Claims

1. A method of reducing the surface recombination rate of silicon discs wherein the steps of the method are carried out in the following sequence
a) cleaning the silicon surface, and thereafter
b) drying the silicon surface,
these steps being carried out in a normal room-atmosphere environment whereafter the following method steps are performed:
c) application of a lacquer at a temperature of less than 100°C, and
d) drying this applied lacquer in a normal room atmosphere for producing an electrically non-conductive layer.

2. A method in accordance with Claim 1, **characterised in that** a lacquer is used which leads to a transparent layer.

3. A method in accordance with Claim 1 or 2, **characterised in that** the lacquer is applied at room temperature of approximately 25 °C.

4. A method in accordance with any of the Claims 1 - 3, **characterised in that** the lacquer comprises an organic basic substance.

5. A method in accordance with Claim 4, **characterised in that** a natural resin or an alkyd resin is used as the basic substance.

6. A method in accordance with Claim 5, **characterised in that** colophony is used.

7. A method in accordance with Claim 5, **characterised in that** alftalate is used.

8. A method in accordance with any of the preceding Claims, **characterised in that** the electrically non-conductive layer contains halogens in a concentration of more than 0.1 vol/%.

9. A method in accordance with Claim 8, **characterised in that** iodine is utilised as the halogen.

10. A method in accordance with Claim 4, **characterised in that** the basic substance of the lacquer substantially consists of polysiloxanes.

11. A method in accordance with any of the preceding Claims, **characterised in that** a further layer in the form of a passivating layer is applied.

12. A method in accordance with any of the Claims 1 - 10, **characterised in that** a transparent, non-conductive foil is applied to the layer.

13. The use of the method in accordance with any of the preceding Claims for producing silicon semiconductor components.

14. The use of the method in accordance with any of the Claims 2 - 12 for preparing a measurement of the minority carrier lifetimes in standard silicon discs.

## Revendications

1. Procédé pour la réduction de la vitesse de recombinaison en surface de pastilles de silicium, dans lequel sont réalisées dans l'ordre indiqué les étapes de procédé
a) de purification de la surface de silicium, et ensuite
b) de séchage de la surface de silicium,
dans un environnement d'atmosphère ambiante normale et en ce que suivent après cela les étapes suivantes de procédé :
c) d'application d'un vernis à une température inférieure à 100°C, et
d) de séchage de ce vernis appliqué dans une atmosphère ambiante normale pour la production d'une couche qui n'est pas électroconductrice.

2. Procédé selon la revendication 1, **caractérisé en ce que** l'on utilise un vernis qui mène à une couche transparente.

3. Procédé selon la revendication 1 ou 2, **caractérisé en ce que** l'on applique le vernis à température ambiante d'environ 25°C.

4. Procédé selon l'une quelconque des revendications 1-3, **caractérisé en ce que** le vernis présente une substance de base organique.

5. Procédé selon la revendication 4, **caractérisé en ce que** l'on utilise comme substance de base une résine naturelle ou une résine alkyde.

6. Procédé selon la revendication 5, **caractérisé en ce que** l'on utilise du colophane.

7. Procédé selon la revendication 5, **caractérisé en ce que** l'on utilise de l'alftalate.

8. Procédé selon l'une quelconque des revendications précédentes, **caractérisé en ce que** la couche non électroconductrice contient des halogènes dans une concentration supérieure à 0,1 % en volume.

9. Procédé selon la revendication 8, **caractérisé en ce que** l'on utilise comme halogène de l'iode.

10. Procédé selon la revendication 4, **caractérisé en ce que** la substance de base du vernis est essentiellement constituée de polysiloxane.

11. Procédé selon l'une quelconque des revendications précédentes, **caractérisé en ce que** l'on applique une autre couche comme couche de passivation.

12. Procédé selon l'une quelconque des revendications 1-10, **caractérisé en ce que** l'on applique une feuille transparente non conductrice sur la couche.

13. Utilisation du procédé selon l'une quelconque des revendications précédentes pour la préparation d'éléments de construction semiconducteurs de silicium.

14. Utilisation du procédé selon l'une quelconque des revendications 2-12 pour la préparation d'une mesure de la durée de vie des porteurs minoritaires dans des pastilles de silicium standard.
